# EUROPÄISCHE PATENTSCHRIFT

(11) **EP 2 803 635 B1**
(45) Veröffentlichungstag und Bekanntmachung des Hinweises auf die Patenterteilung: **06.02.2019**
(21) Anmeldenummer: 14168566.9
(22) Anmeldetag: 16.05.2014
(51) Int. Cl.: B81C 1/00

(54) **Vorrichtung mit einer Feder und einem daran aufgehängten Element und Verfahren zum Herstellen desselben**
Device with a spring holding an element, and method for manufacturing the same
Dispositif ayant un ressort supportant un élément, et méthode de fabrication de celui-ci

(30) Priorität: 17.05.2013 DE 102013209238
(43) Veröffentlichungstag der Anmeldung: 19.11.2014
(60) Teilanmeldung: 17205899.2
(73) Patentinhaber: Fraunhofer-Gesellschaft zur Förderung der angewandten Forschung e.V., 80686 München (DE)
(72) Erfinder: Gu-Stoppel, Shanshan, 25524 Itzehoe (DE); Quenzer, Hans Joachim, 25524 Itzehoe (DE); Hofmann, Ulrich, 25524 Itzehoe (DE)
(74) Vertreter: Schenk, Markus

(56) Entgegenhaltungen:
- EP-A1- 2 100 848
- US-A1- 2006 180 883

## Beschreibung

Die vorliegende Erfindung bezieht sich auf eine Vorrichtung mit einer aus einem Stapel gebildeten Feder und einem über die Feder aufgehängten Element sowie ein Verfahren zum Herstellen desselben aus einem Stapel, bestehend aus einem Substrat und Halbleiterschichten.

Bei den meisten piezoelektrischen Mikroscannern wird der Mikrospiegel von Aktuatoren angetrieben, die aus einer, von zwei Elektroden umschlossenen, piezoelektrischen Schicht und einer darunter liegenden Trägerschicht bestehen und im Sinne von Biegebalken funktionieren. Die an zwei gegenüberliegenden Außenseiten des Mikroscanners angeordneten piezoelektrischen Aktuatoren werden gegenphasig angetrieben, so dass der zwischen den Aktuatoren angeordnete und über Torsionsfedern an den Aktuatoren aufgehängte Spiegel in einer Torsionsmode eines aus dem Spiegel, den Aktuatoren und den Federn gebildeten Feder-Masse-Systems schwingt. Zum Aufbau eines solchen Systems sind unterschiedliche Schichtdicken nötig, um die jeweiligen Funktionen der verschiedenen Bestandteile zu realisieren.

Meist wird eine geringe Schichtdicke der Aktuatoren angestrebt, um hohe Auslenkungen zu ermöglichen. Die Auslenkung eines Biegebalkens nimmt bei konstanter Kraft mit abnehmender Schichtdicke zu. Die Aktuatoren sollen jedoch meist eine gewisse Schichtdicke nicht unterschreiten, da zu dünne Aktuatoren eine sehr niedrige Resonanzfrequenz und eine schlechte strukturelle Stabilität aufweisen.

Der Spiegel des Mikroscanners erfordert eine gewisse minimale Dicke, um dynamische Deformationen der Reflexionsfläche des Spiegels, die durch die dynamische Anregung der Aktuatoren angeregt werden, zu minimieren.

Die Schichtdicke der Torsionsfedern, an welchem der Spiegel aufgehängt ist, ist meist sehr genau bestimmt, um einen Kompromiss zwischen der zu minimierenden Materialbelastung beim Tordieren und einer gewünschten hohen Resonanzfrequenz einzugehen. Während eine erhöhte Schichtdicke der Torsionsfedern die Resonanzfrequenz des Feder-Masse-Systems in gewünschter Weise erhöht, nimmt dadurch auch der durch Verformung der Torsionsfeder im Betrieb induzierte Materialstress zu, was zu einem frühzeitigen Ausfall des Mikroscanners führen kann.

Versteifungsfedern zwischen den Torsionsfedern und den Aktuatoren sollen dick genug sein, um ungewollte, durch die Aktuatoren induzierte, Deformationen an diesen Stellen zu vermeiden. Die Versteifungsfedern können eine größere Dicke als die Aktuatoren aufweisen.

Folglich weist eine MEMS (Micro Electro Mechanical Systems)-Struktur in Form eines Mikroscanners verschiedene Bereiche mit idealerweise von einander verschiedenen Schichtdicken auf, wobei die Schichtdicken mit einem hohen Freiheitsgrad bestimmt und mit hoher Genauigkeit umgesetzt werden müssen. Durch die exakte Bestimmung der Parameter, und damit insbesondere der Schichtdicken können die mechanischen und dynamischen Eigenschaften der MEMS-Struktur optimiert werden.

Gängige Verfahren zur Realisierung von Mikroscannern unter Nutzung von piezoelektrischen Aktuatoren ermöglichen eine Schichtdickendifferenz zwischen den Aktuatoren, den Versteifungsfedern und dem anzutreibenden Mikrospiegel. Die Schichtdickendifferenz ist jedoch kaum in gewünschter Weise justierbar, da die Trägerschicht der Aktuatoren in ihrer maximalen Dicke darin beschränkt ist, wie es der eingesetzte Beschichtungsprozess, beispielsweise eine thermische Oxidation, zulässt. Dies sind in den meisten Fällen nur einige Mikrometer. Aktuatoren mit diesen Schichtdicken können jedoch keine hohe Resonanzfrequenz und Stabilität erzielen. Auch bietet dieses Verfahren keine Möglichkeit, die zwischen den Aktuatoren und den Torsionsfedern angeordneten Versteifungsfedern in einer optimalen Dicke auszubilden, da der Herstellungsprozess lediglich auf einer Siliziumschicht, welche, durch eine Oxidschicht getrennt, an einer Substratschicht angeordnet ist, beruht und die Schichtdicke der Siliziumschicht, mit Ausnahme der vergleichsweise dünnen Oxidschicht, die maximale Dicke der Versteifungsfedern beschreibt. Ein Entfernen einzelner Materialschichten zur Ausbildung von Bereichen unterschiedlicher Dicke erlaubt aufgrund der lediglich zwei Materialschichten und der Oxidschichten lediglich eine begrenzte Anzahl von Bereichen unterschiedlicher Schichtdicke.

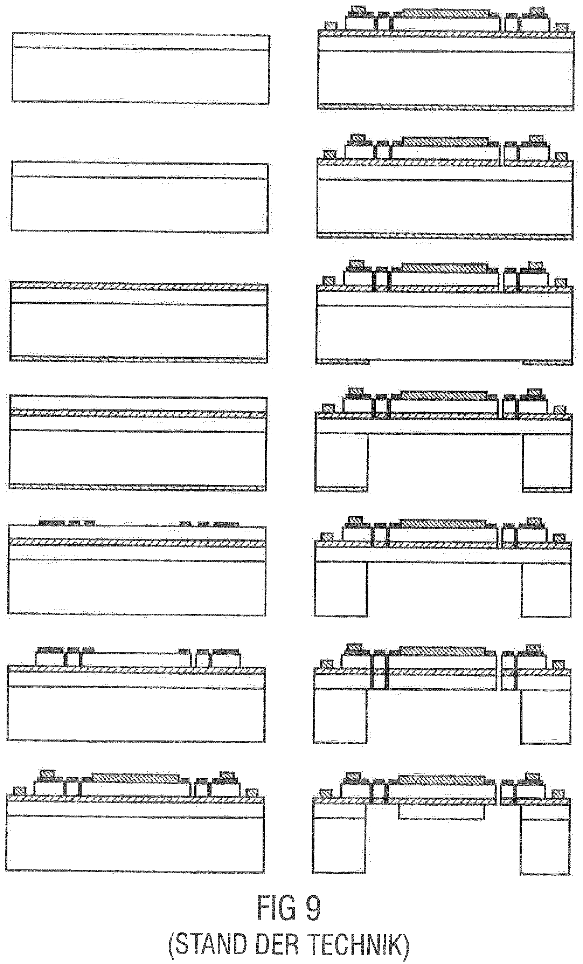

Der Ablauf eines solchen Prozesses ist in Fig. 9 dargestellt.

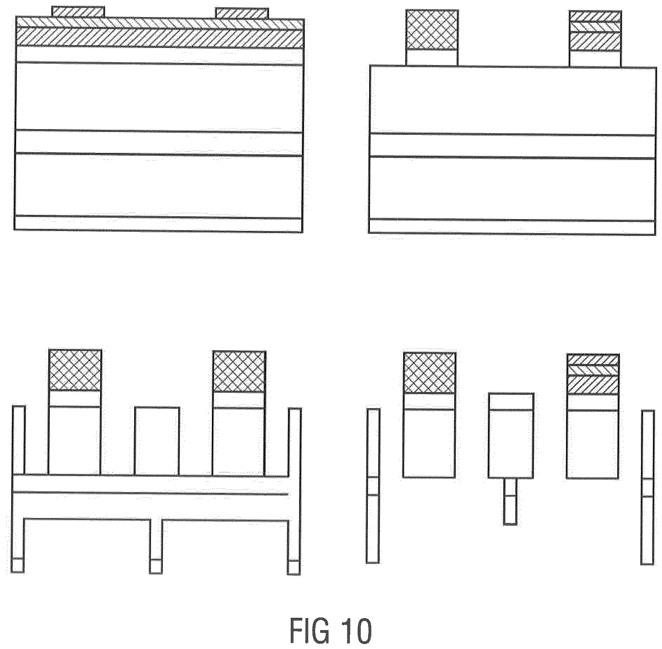

Ein weiteres und in Fig. 10 beschriebenes Verfahren bietet die Möglichkeit, mit relativ kleinem Aufwand eine Schichtdickendifferenz zwischen den Aktuatoren und dem Spiegel zu schaffen. Die dünn auszubildenden Aktuatoren werden durch rückseitiges Ätzen zeitkontrolliert vorgeätzt, wobei der vergleichsweise dicker auszubildende Spiegel anschließend gemeinsam mit den vorgeätzten Aktuatoren weitergeätzt wird. Mit dieser Methode sind die Schichtdicken der Aktuatoren beliebig einstellbar, da die Trägerschicht aus Silizium besteht und daher während eines Ätzprozesses in eine relativ beliebige Schichtdicke gebracht werden kann. Die Genauigkeit der Schichtdicken über die lateralen Ausdehnungen der Schichten sowie der Winkel einer Ätzkante sind aber wegen der inhomogenen Ätzrate über den ganzen Wafer schwer zu garantieren. Diese Methode ist somit lediglich geeignet, Schichtdicken in den mechanisch passiven Bereichen einzustellen, beispielsweise den Spiegel oder die Versteifungsfedern. Für die mechanisch aktiven Bereiche wie die Torsionsfedern, deren Eigenschaften, insbesondere die Eigenfrequenz und die Dauerbelastbarkeit, von der Schichtdicke beeinflusst und bestimmt werden, ist das Verfahren aufgrund vorgenannter Ungenauigkeiten nicht verwendbar, da die notwendigerweise genau zu berechnende Schichtdicke der Torsionsfeder nicht realisierbar ist.

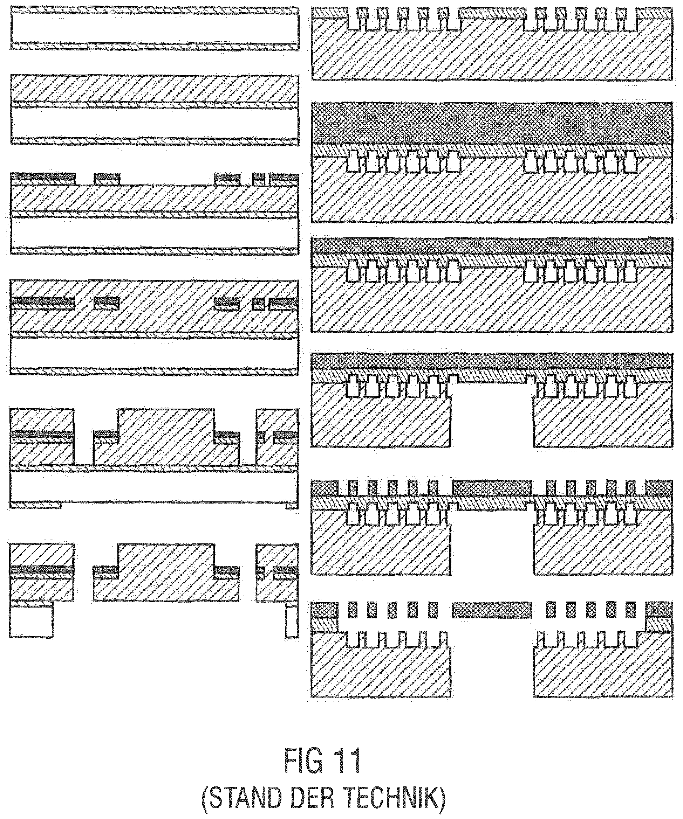

Ein weiteres, in Fig. 11 beschriebenes Verfahren zur Herstellung elektrostatisch betriebener Bauteile, beispielsweise aus einem SOI (Silicon on Insulator)-Wafer, welcher aus zwei Siliziumschichten mit gleicher Schichtdicke besteht, zwischen denen die Funktionsschichten angeordnet sind. Das Verfahren umfasst die Strukturierung und Ausformung der Schichten von einer Oberseite des SOI-Wafers hin zu einer Rückseite des SOI-Wafers. Diese Technologie ist jedoch für piezoelektrische Aktuatoren ungeeignet. Die Funktionsschichten für piezoelektrische Antriebe, piezoelektrische Schichten und Elektroden, werden idealerweise an der obersten Oberfläche angeordnet. Da es für piezoelektrische Materialien vorteilhaft ist, wenn der Beschichtungsprozess an unstrukturierten Wafern durchgeführt wird, ist eine vorherige Strukturierung von der Oberseite, an welcher die Funktionsschichten angeordnet werden, kontraproduktiv.

Ein weiteres Beispiel für ein Herstellungsverfahren von MEMS-Bauteile mit elektrostatischen Antrieben umfasst einen Schritt eines Zusammenbondens eines strukturierten Wafers mit einem zweiten, abgeschliffenen Wafer und eine anschließende Beschichtung uns Strukturierung des Stapels von einer Hauptseite aus. Durch ein Abschleifen des zweiten Wafers kann eine Dicke des Wafers eingestellt werden. Da piezoelektrische Aktuatoren jedoch Schichtdicken von einigen Mikrometern erfordern, müssten also Wafer bis auf eine derartig geringe Dicke abgeschliffen werden. Mit diesem Verfahren sind piezoelektrische Aktuatoren in MEMS-Bauteilen nur mit einem unangemessenen Aufwand herstellbar. Zudem ist die Justage der zwei zu bondenden Wafer zueinander schwer und erhöht die Komplexität des Herstellungsprozesses.

In US 2006/0180883 A1 ist ein mikro-oszillierendes Element beschrieben, das einen Rahmen, einen beweglichen funktionellen Bereich und eine Torsionsverbindung aufweist, um den beweglichen funktionellen Bereich mittels Kammelektroden auszulenken.

Wünschenswert wäre demnach eine MEMS-Struktur, deren einzelne Komponenten eine von einander verschiedene Dicke aufweisen und kostengünstiger oder effektiver hergestellt werden können.

Die Aufgabe der vorliegenden Erfindung besteht deshalb darin, eine MEMS-Struktur aus einem Stapel mit Schichten bereitzustellen sowie ein Verfahren zum Herstellen desselben zu schaffen, die eine effektivere Herstellbarkeit erlauben.

Diese Aufgabe wird durch den Gegenstand der unabhängigen Patentansprüche gelöst.

Der Kerngedanke der vorliegenden Erfindung besteht deshalb darin, erkannt zu haben, dass obige Aufgabe dadurch gelöst werden kann, dass durch Bilden eines Stapels aus zumindest einem Substrat und zwei Halbleiterschichten mit dazwischen liegenden Ätzstoppschichten sowie durch rückseitiges Entfernen verschiedener Schichten ein Feder-Masse-System ausgebildet werden kann, welches in seiner Dicke variiert.

Gemäß einem Ausführungsbeispiel wird ein Stapel aus einer Silizium- und zwei Polysiliziumschichten gebildet, wobei zwischen den Schichten jeweils eine Oxid-Schicht angeordnet ist und die Siliziumschicht als Substrat dient. Vor einer Ausformung von Federn und Massen des Feder-Masse-Systems werden die piezoelektrischen Funktionsschichten an einer ebenen Hauptseite des Stapels angeordnet und eine Ätzstoppschicht mit lokal variierender Schichtdicke ausgebildet. Eine MEMS-Struktur umfasst einem Stapel mit einem Substrat, einer ersten Ätzstoppschicht, einer ersten Halbleiterschicht, einer zweiten Ätzstoppschicht, einer zweiten Halbleiterschicht, die in der genannten Reihenfolge auf einander angeordnet sind. Das MEMS umfasst ferner ein in dem Stapel gebildetes Feder-Masse-System mit zumindest einer Feder und einem über die Feder aufgehängten Element. Das Feder-Masse-System variiert in einer Dicke, indem von einer der ersten Ätzstoppschicht abgewandten Rückseite des Substrates aus an einer ersten Stelle das Substrat unter Verbleib der ersten Halbleiterschicht; und an einer zweiten, lateral von der ersten Stelle verschiedenen Stelle das Substrat, die erste Ätzstoppschicht und die erste Halbleiterschicht entfernt sind. Eine Aktuatorschicht ist so angeordnet, dass die zweite Halbleiterschicht zwischen der zweiten Ätzstoppschicht und der Aktuatorschicht angeordnet ist und so einen Aktuator für das Feder-Masse-System ausbildet.

Die Vorrichtung ist mit hoher Präzision herstellbar, so dass die Parameter, wie beispielsweise Resonanzfrequenzen, genau und reproduzierbar einstellbar sind.

Weitere vorteilhafte Ausführungsformen sind Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1a-b: eine Aufsicht und Querschnittansichten einer MEMS-Struktur mit einem schwingfähig aufgehängten Mikrospiegel;
- Fig. 2: eine Querschnittansicht eines Stapels mit mehreren Schichten;
- Fig. 3a-e: die einzelnen Schritte des Anordnens unterschiedlicher Schichten zu einem Stapel;
- Fig. 4: die Anordnung von Aktuatoren auf dem Stapel;
- Fig. 5: ein lokal selektives Entfernen von Schichten von einer Oberseite des Stapels aus;
- Fig. 6: ein lokal selektives Entfernen von Schichten von einer Rückseite des Stapels aus;
- Fig. 7: ein lokal selektives Entfernen von Materialschichten von einer Rückseite des Stapels aus in einer alternativen Querschnittebene;
- Fig. 8: ein lokal selektives Entfernen von Materialschichten von einer Rückseite des Stapels aus in einer weiteren Querschnittebene;
- Fig. 9: ein Verfahren zur Herstellung einer MEMS-Struktur gemäß dem Stand der Technik durch rückseitiges Ätzen;
- Fig. 10: ein alternatives Verfahren zur Herstellung einer MEMS-Struktur gemäß dem Stand der Technik durch ein zeitkontrolliertes Vorätzen;
- Fig. 11: ein weiteres Verfahren zur Herstellung einer MEMS-Struktur gemäß dem Stand der Technik, mit einem.

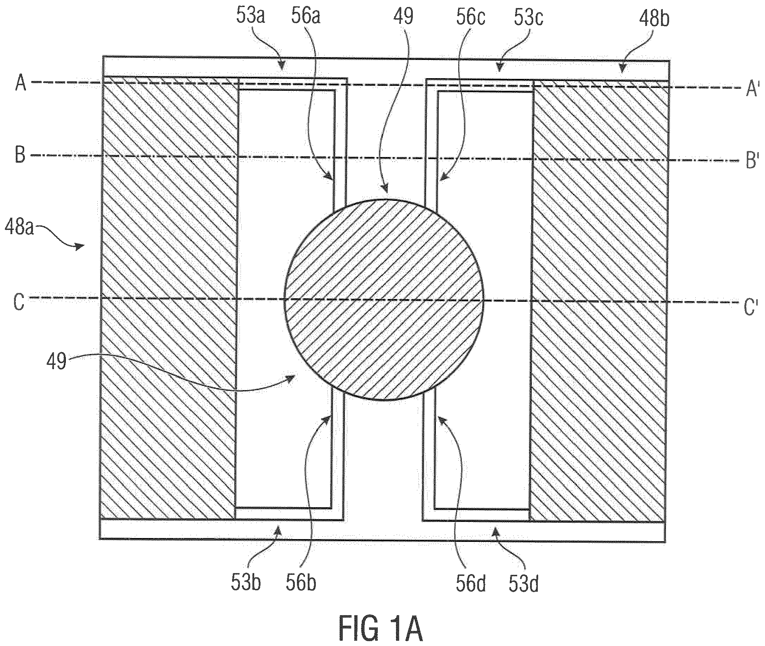

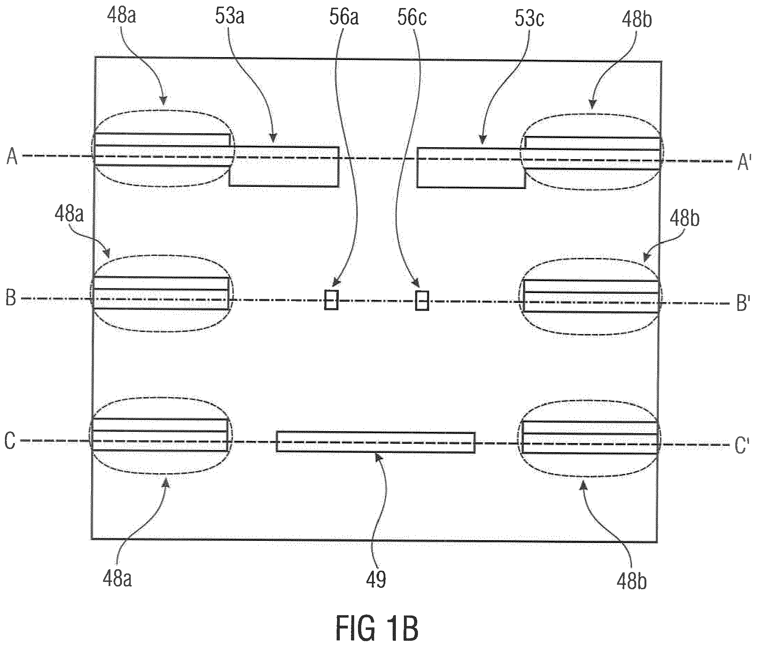

Fig. 1a zeigt eine Aufsicht auf eine MEMS-Struktur mit einem über Torsionsfedern 56a-d und Versteifungsfedern 53a-d an Aktuatoren 48a und 48b aufgehängten Mikrospiegel 49. Die gestrichelt eingezeichneten Linien A-A', B-B' und C-C' bezeichnen Querschnittebenen für welche in Fig. 1b der Aufbau der MEMS-Struktur im Querschnitt beschrieben ist.

Fig. 1b zeigt für die Querschnittebene A-A' die Aktuatoren 48a und 48b sowie die Versteifungsfedern 53a und 53c, welche gegenüber den Aktuatoren 48a und 48b eine größere Dicke aufweisen. Für die Querschnittebene B-B' zeigt Fig. 1b die Torsionsfedern 56a und 56c, welche gegenüber den Versteifungsfedern 53a und 53c eine geringere Dicke aufweisen. Dadurch sind die Torsionsfedern 56a und 56c gegenüber durch die Aktuatoren 48a und 48b induzierten Bewegungen nachgiebiger als die Versteifungsfedern 43a und 53c. Für die Querschnittebene C-C' zeigt Fig. 1b den zwischen den Aktuatoren 48a und 48b angeordneten Mikrospiegel 49. Dieser weist eine etwa gleichgroße Dicke wie die Torsionsfedern 56a und 56c und der Aktuatoren 48a und 48b auf.

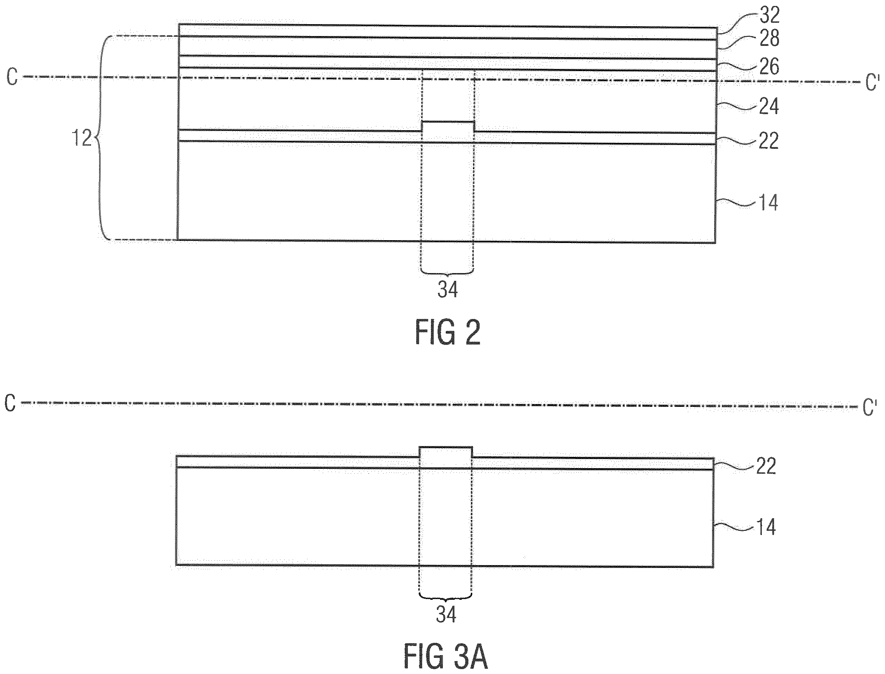

Fig. 2 zeigt in der Querschnittebene C-C' das Bereitstellen eines Stapels 12 mit einem Substrat 14, welches beispielsweise aus einer Siliziumschicht gebildet ist. An einer, eine Oberseite des Substrates 14 definierenden Hauptseite des Substrates 14 ist eine erste Ätzstoppschicht 22 angeordnet, an deren dem Substrat 14 abgewandten Oberfläche eine erste Halbleiterschicht 24 angeordnet ist. Die der ersten Ätzstoppschicht 22 abgewandte Hauptseite der ersten Halbleiterschicht 24 wird von einer zweiten Ätzstoppschicht 26 bedeckt, an deren der ersten Halbleiterschicht 24 abgewandten Hauptseite wiederum die zweite Halbleiterschicht 28 angeordnet ist. Der bereitgestellte Stapel 12 wird an einer dem Substrat 14 abgewandten Hauptseite, welche eine Oberseite des Stapels 12 definiert, von einer Isolationsschicht, die bspw. eine nichtleitende Ätzschicht, 32 bedeckt. Die erste und zweite Halbleiterschicht 24 und 28 des bereitgestellten Stapels 12 können beispielsweise aus Polysilizium gebildet sein, wohingegen die erste und zweite Ätzstoppschicht 22 und 26 möglicherweise aus Siliziumoxid bestehen. Die Isolationsschicht ist aus elektrisch nicht leitenden Materialien gebildet, die einen elektrischen Kontakt von ersten Elektroden 36a und 36b zur zweiten Halbleiterschicht 28 verhindern.

Die Dicken der ersten Halbleiterschicht 24 und der zweiten Halbleiterschicht 28 sind von einander verschieden und so gewählt, wie es die Dicke einzelner Komponenten der späteren MEMS-Struktur erfordert. Während eines späteren Ätzprozesses wird eine Dicke einer Ätzstoppschicht wesentlich langsamer abgetragen als eine Halbleiterschicht vergleichbarer Dicke. Dadurch ist es möglich, durch eine Maskierung von lateralen Stellen einer Halbleiterschicht von der Maske unbedeckte Bereiche der jeweiligen Halbleiterschicht zu entfernen, wohingegen Bereiche, die von der Maske bedeckt werden, nicht abgetragen werden, da der Ätzprozess die vergleichsweise dünn ausgebildete Ätzstoppmaske nur sehr langsam entfernt. Durch eine Maskierung mit einer minimalen und über die laterale Ausdehnung variierenden Dicke der Maske können Funktionsschichten von einander getrennt werden. Wird die minimale Dicke der Ätzstoppschicht entfernt, verbleiben restliche axiale Ausdehnungen im Sinne einer Ätzstoppmaske, die eine Entfernung von maskierten Bereichen verhindern. Die Maskierung der Oxid-Schichten kann insbesondere so erfolgen, dass inselähnliche Ätzstoppbereiche ausgebildet sind.

Die erste Ätzstoppschicht 22 weist in einem lateralen Verlauf einen Bereich 34 auf, entlang dessen lateraler Ausdehnung die erste Ätzstoppschicht 22 eine größere Dicke als im restlichen lateralen Verlauf des Stapels 12 aufweist. Die Veränderung der Schichtdicke der ersten Ätzstoppschicht 22 im Bereich 34 ist dabei stufenartig ausgebildet. Die an der ersten Ätzstoppschicht angeordnete erste Halbleiterschicht 24 weist über eine laterale Ausdehnung der Schicht 24 ebenfalls eine veränderliche Schichtdicke auf, wobei die erste Halbleiterschicht 24 im Bereich 34 stufenartig in dem Maße dünner ausgebildet ist, in dem die erste Ätzstoppschicht 22 im Bereich 34 dicker ausgebildet ist, sodass eine der ersten Ätzstoppschicht 22 abgewandte Hauptseite der ersten Halbleiterschicht eben ausgebildet ist. Die weiteren Schichten 26, 28 und 32 weisen ebenfalls ebene Oberflächen auf.

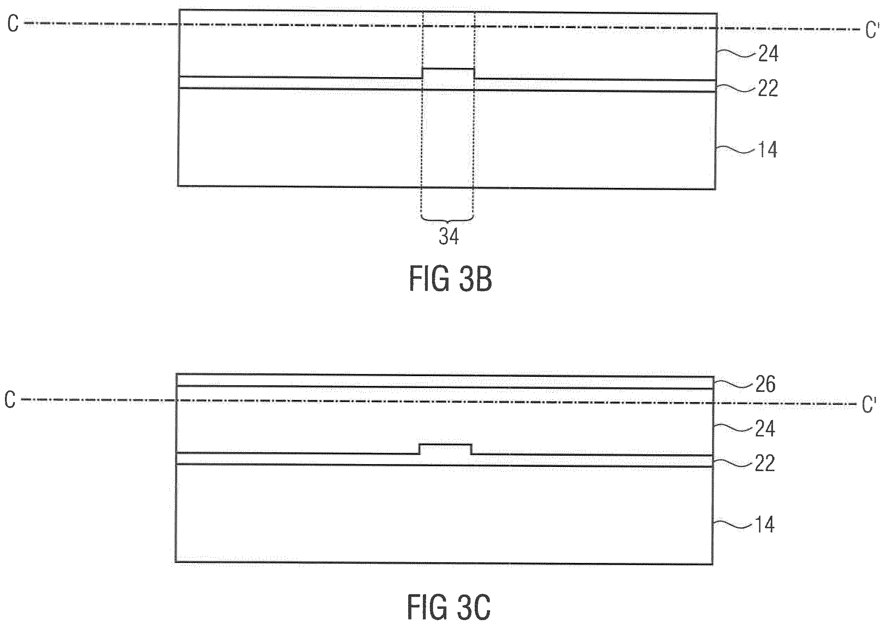

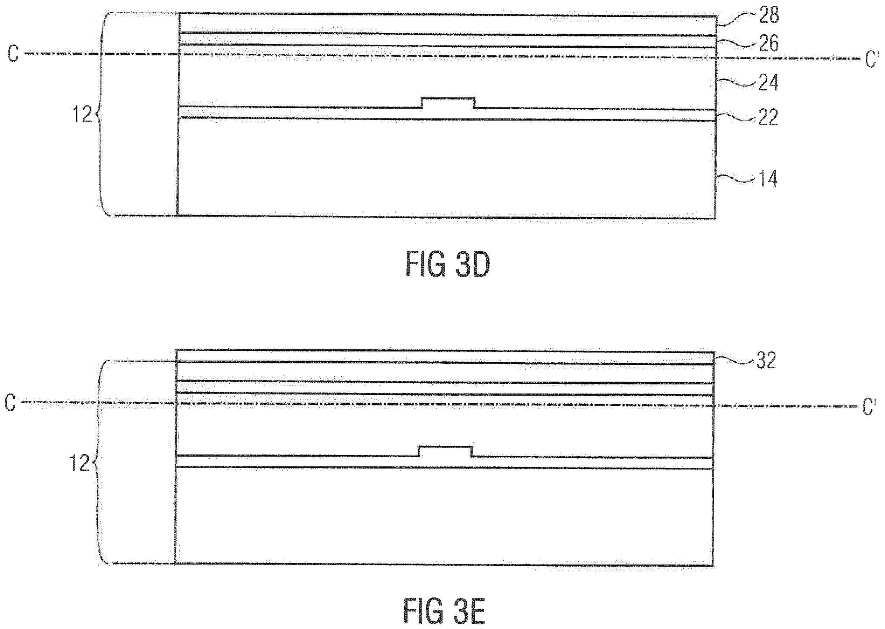

Der Stapel 12 dient als Ausgangswerkstück für die folgenden Verfahrensschritte. Die konsekutive Übereinanderordnung der einzelnen Schichten ist in nachfolgender Fig. 3 dargestellt.

Fig. 3a zeigt in der Querschnittebene C-C' die Anordnung des Substrats 14 sowie die Anordnung der ersten Ätzstoppschicht 22 an einer die Oberseite definierenden Hauptseite des Substrats 14. Das Substrat 14 bildet mit der der Oberseite des Substrats gegenüberliegenden Hauptseite die Rückseite des konsekutiv gebildeten Stapels 12.

Nachfolgend werden Hauptseiten einer Schicht oder des Stapels 12, die der Rückseite des Stapels 12 abgewandt angeordnet sind respektive werden als Oberseiten und Hauptseiten einer Schicht, die der Rückseite des Stapels 12 zugewandt sind, als Rückseiten bezeichnet. Diese Bezeichnungen dienen der Anschaulichkeit, ohne eine Orientierung des Stapels oder seiner Schichten im Raum oder in einer Anordnung zu definieren.

Die erste Ätzstoppschicht 22 wird derart an dem Substrat angeordnet, dass im Bereich 34 eine stufenartige Erhöhung der Schichtdicke ausgebildet und damit eine Maskierung respektive Maske angeordnet wird. Damit wird für die späteren Ätzprozesse eine Maske ausgebildet. Zum Anordnen der ersten Ätzstoppschicht 22 kann beispielsweise ein thermischer Oxidationsprozess genutzt werden.

Fig. 3b zeigt in der Querschnittebene C-C' den darauf folgenden Schritt der Anordnung der ersten Halbleiterschicht an der Oberseite der ersten Ätzstoppschicht 22. Das Anordnen kann beispielsweise mit einem Epitaxie-Verfahren durchgeführt werden. Die stufenartig unebene Ausführung der ersten Ätzstoppschicht 22 wird durch das Anordnen der ersten Halbleiterschicht derart ausgeglichen, dass die Oberseite der ersten Halbleiterschicht 24 eben ausgebildet wird. Im Bereich 34 der ersten Halbleiterschicht 24 führt diese Verfahrensweise dazu, dass die erste Halbleiterschicht 24 im Bereich 34 mit einer geringeren Dicke ausgebildet ist als im Verlauf ihrer restlichen lateralen Ausdehnung. Für die Anordnung der weiteren, folgenden Schichten ist die Anordnung der Maskierung durch die erste Ätzstoppschicht 22 insofern nicht relevant, als die weiteren Schichten auf einer ebenen Oberfläche abgelegt werden können. Dadurch vereinfachen sich die weiteren Verfahrensschritte erheblich gegenüber existierenden Verfahren, die eine Maskierung an einer außen liegenden Hauptseite einer zu ätzenden Halbleiter- oder Substratschicht beinhalten. Beispielsweise für Aktuatoren anzuordnende Funktionsschichten werden bevorzugt auf ebenen Waferoberflächen angeordnet. Ist eine Oberfläche eines Stapels aufgrund einer Maskierung uneben ausgebildet, erhöht dies die Komplexität der Anordnung der Funktionsschichten.

Fig. 3c zeigt in der Querschnittebene C-C' die Anordnung der zweiten Ätzstoppschicht 26 an einer Oberseite der ersten Halbleiterschicht 24.

Fig. 3d zeigt in der Querschnittebene C-C' die Anordnung der zweiten Halbleiterschicht 28 an einer Oberseite der zweiten Ätzstoppschicht 26. Die zweite Halbleiterschicht 28 wird dabei mit einer von der ersten Halbleiterschicht 24 verschiedenen Schichtdicke angeordnet, wobei prinzipiell auch denkbar ist, dass die erste Halbleiterschicht 24 und die zweite Halbleiterschicht 28 identische Schichtdicken aufweisen. Das Substrat 14, die erste Ätzstoppschicht 22, die erste Halbleiterschicht 24, die zweite Ätzstoppschicht 26 und die zweite Halbleiterschicht 28 bilden nach erfolgter Anordnung der Schichten den Stapel 12 aus, welcher für nachfolgende Schritte bereitgestellt wird.

Fig. 3e zeigt in der Querschnittebene C-C' die Anordnung der Isolationsschicht 32, über die laterale Ausdehnung des Stapels 12 um eine konsekutive Anordnung von Funktionsschichten zu ermöglichen.

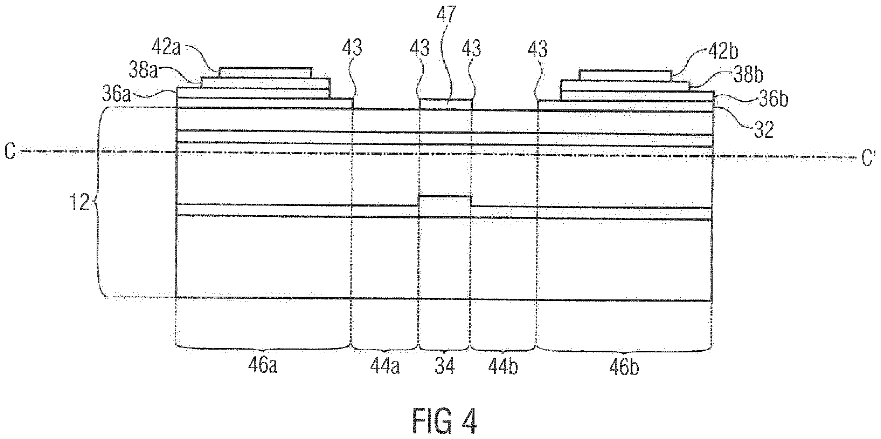

Fig. 4 zeigt in der Querschnittebene C-C' den Verfahrensschritt der Anordnung von ersten Elektroden 36a und 36b, piezoelektrischem Material 38a und 38b und zweiten Elektroden 42a und 42b an dem Stapel 12 respektive einer Oberseite der Isolationsschicht 32. An der Oberseite der Isolationsschicht 32 werden nacheinander erste Elektroden 36a und 36b, piezoelektrisches Material 38a und 38b sowie zweite Elektroden 42a und 42b angeordnet. Die Anordnung der Elektroden 36a, 36b, 42a und 42b erfolgt derart, dass das piezoelektrische Material 38a zwischen der ersten Elektrode 36a und der zweiten Elektrode 42a sowie das piezoelektrische Material 38b zwischen der ersten Elektrode 36b und der zweiten Elektrode 42b angeordnet wird. Dabei wird die zweite Elektrode 42a respektive 42b bezüglich der ersten Elektrode 36a respektive 36b derart angeordnet, dass die zweite Elektrode 42a respektive 42b die erste Elektrode 36a respektive 36b nicht berührt und ein Kurzschluss verhindert ist. Weiterhin wird die Isolationsschicht 32 durch eine Strukturierung 43 in mehrere laterale Bereiche 44a, 44b, 46a und 46b aufgeteilt. Die Strukturierung 43 kann dabei beispielsweise durch eine Durchtrennung oder ein Durchschneiden der Isolationsschicht 32 ausgeführt werden. Die Bereiche 44a und 44b sind dabei freizulegende Bereiche, während die Bereiche 46a und 46b zu Aktuatorbereichen ausgeformt werden.

In den freizulegenden Bereichen 44a und 44b sowie dem Bereich 34 wird die Isolationsschicht 32 entfernt, beispielsweise durch einen Schleif- oder Ätzprozess. Anschließend wird im Bereich 34, in welchem später eine bewegliche Struktur ausgebildet wird, eine Reflexionsschicht 47 an der Oberseite der zweiten Halbleiterschicht 28 angeordnet. Diese kann beispielsweise eine Aluminium- oder Silberschicht umfassen, um eine eintreffende Lichtleistung, möglicherweise einen Laserstrahl, zu reflektieren. Wenn die aus dem Stapel 12 gebildete Struktur für eine nicht-optische Anwendung eingesetzt wird, kann möglicherweise auf eine reflektierende Oberfläche verzichtet werden.

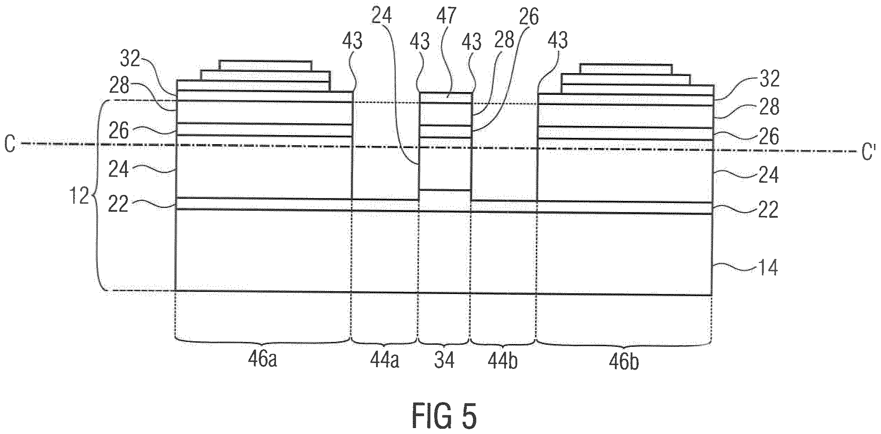

Fig. 5 zeigt in der Querschnittebene C-C' das Entfernen der zweiten Halbleiterschicht 28, der zweiten Ätzstoppschicht 26 sowie der ersten Halbleiterschicht 24 in den freizulegenden Bereichen 44a und 44b von der Oberseite der zweiten Halbleiterschicht 28 aus. Das Entfernen kann beispielsweise durch einen Ätzprozess ausgeführt werden. Nach der Entfernung der Schichten von einer Oberseite des Stapels aus sind die erste Halbleiterschicht 24, die zweite Ätzstoppschicht 26, die zweite Halbleiterschicht 28 sowie die Isolationsschicht 32 in lateraler Richtung entlang des Verlaufs der Strukturierung 43 durchtrennt, wobei im Bereich 34 an der zweiten Halbleiterschicht die Reflexionsschicht 47 angeordnet ist.

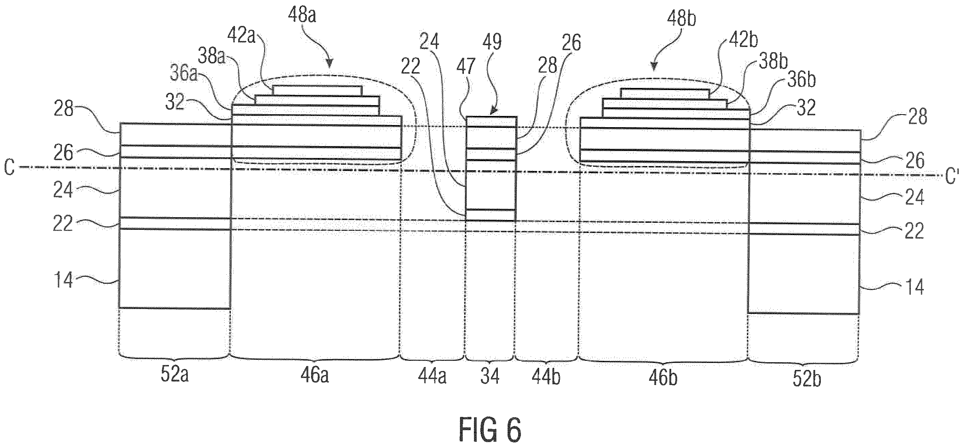

Fig. 6 zeigt in der Querschnittebene C-C' den Schritt des Entfernens des Substrats 14, der ersten Halbleiterschicht 24 sowie Teilen der ersten Ätzstoppschicht 22 von der Rückseite des Stapels aus. Für das Entfernen kann ebenfalls ein Ätzprozess genutzt werden, welcher in den Bereichen 46a, 46b, 44a, 44b und 34 zuerst flächig das Substrat 14 entfernt. Anschließend wird die erste Ätzstoppschicht 22 in eben jenen Bereichen abgetragen respektive weggeätzt. Ist die erste Ätzstoppschicht 22 in den Bereichen 46a, 44a, 44b sowie 46b entfernt, so sind die Bereiche 44a und 44b in axialer Richtung vollständig freigelegt. In den Bereichen 46a und 46b bewirkt die Abwesenheit der Ätzstoppschicht 22, dass das Entfernen, beispielsweise der Ätzprozess, konsekutiv an der ersten Halbleiterschicht 24 angreift. Dahingegen ist aufgrund der Maskierung und mithin dem Vorhandensein eines Teils der ersten Ätzstoppschicht 22 in einem axialen Verlauf des Bereichs 34 die erste Halbleiterschicht 24 von der Rückseite des Stapels aus weiterhin mit der ersten Ätzstoppschicht 22 bedeckt. Durch Fortführen des Ätzprozesses wird im weiteren Verlauf des Verfahrens die erste Halbleiterschicht in den Bereichen 46a und 46b entfernt, währen die erste Ätzstoppschicht 22 im Bereich 34 teilweise verbleibt und ein Entfernen der ersten Halbleiterschicht 24 im Bereich 34 verhindert ist. Durch das teilweise Entfernen der Schichten in den Aktuatorbereichen 46a und 46b verbleiben die zweite Ätzstoppschicht 26, die zweite Halbleiterschicht 28 sowie die Isolationsschicht 32, die ersten Elektroden 36a und 36b, die piezoelektrischen Materialien 38a und 38b sowie die zweiten Elektroden 42a und 42b in den axialen Verläufen der Aktuatorbereiche 46a und 46b.

Diese in den Bereichen 46a und 46b verbleibenden Schichten bilden die Aktuatoren 48a und 48b. Dabei sind die Aktuatoren 48a und 48b derart ausgebildet, dass ein Anlegen einer elektrischen Spannung zwischen der ersten Elektrode 36a respektive 36b und der zweiten Elektrode 42a respektive 42b zu einer Verformung des piezoelektrischen Materials 38a respektive 38b führt. Diese Verformung, beispielsweise eine Kontraktion, des piezoelektrischen Materials 36a respektive 36b führt zu einer Auslenkung der an der ersten Elektrode angeordneten Schichten, die sich dann wie ein Biegebalken verhalten. Dabei stützen sich die Aktuatoren 48a und 48b am peripheren Bereich 52a und 52b ab. Die Bereiche 52a und 52b können dabei Teil des initialen Stapels oder nachträglich angeordnet sein. Sie sind ausgebildet, einen Ankerpunkt des durch die vorangegangenen Verfahrensschritte ausgebildeten Feder-Masse-Systems zu bilden. Die im axialen Verlauf des Bereichs 34 verbleibenden Schichten bilden den Mikrospiegel 49 mit der Reflexionsschicht 47 aus.

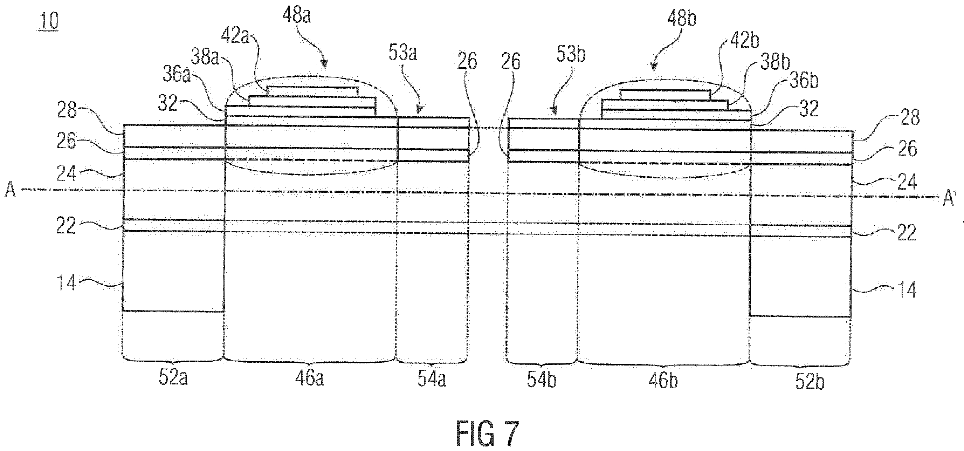

Fig. 7 zeigt eine alternative, mittels des beschriebenen Verfahrens hergestellte, MEMS-Struktur 10 in der Querschnittebene A-A'. In den Aktuatorbereichen 46a und 46b sind durch rückseitiges Entfernen das Substrat 14, die erste Ätzstoppschicht 22, die erste Halbleiterschicht 24 sowie die zweite Ätzstoppschicht 26 entfernt. In Versteifungsfederbereichen 54a und 54b ist die zweite Ätzstoppschicht 26 weiterhin angeordnet, so dass Versteifungsfedern 53a und 53b der MEMS-Struktur gegenüber den Aktuatoren 48a und 48b unter Vernachlässigung der Elektroden und piezoelektrischen Funktionsschichten eine größere Dicke aufweisen. Die zweite Ätzstoppschicht 26 ist durch das lokal selektive Verfahren in den Aktuatorbereichen 46a und 46b sowie im Bereich zwischen den Versteifungsfederbereichen 54a und 54b entfernt.

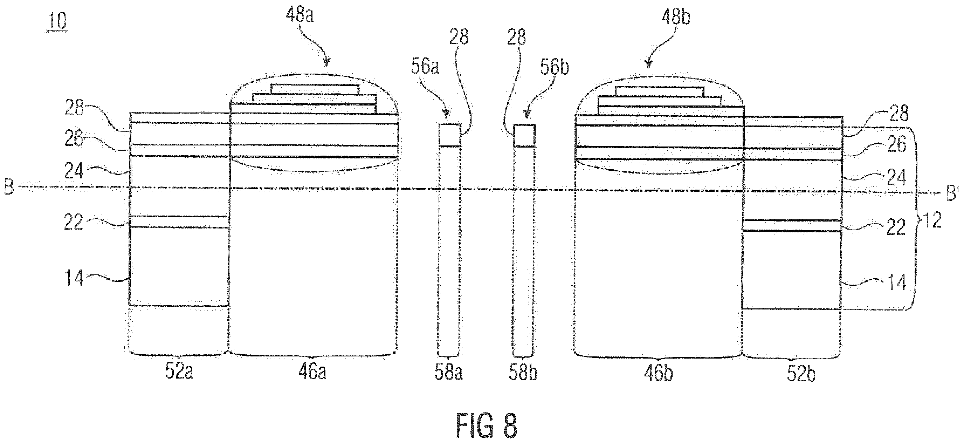

Fig. 8 zeigt eine Querschnittansicht der MEMS-Struktur 10 in der Querschnittebene B-B', in welcher Torsionsfedern 56a und 56b in den Torsionsfederbereichen 58a und 58b dargestellt sind. In den Torsionsfederbereichen 58a und 58b sind mit Ausnahme der zweiten Halbleiterschicht 26 sämtliche anderen Schichten des Stapels entfernt, wobei beispielsweise durch selektives Ätzen von der Rückseite des Stapels 12 aus die Torsionsfedern 56a und 56b ausgebildet sind.

Obwohl in Fig. 8 die Torsionsfedern 56a und 56b lediglich durch die zweite Halbleiterschicht 28 ausgeformt werden, ist ebenfalls denkbar, dass währen des Entfernens von Schichten von der Rückseite des Stapels aus die zweite Ätzstoppschicht 26, die erste Halbleiterschicht 24 oder die erste Ätzstoppschicht 22 jeweils mit den im Stapel darüber angeordneten Schichten verbleibt. Prinzipiell können über die laterale Ausdehnung und in unterschiedlichen Querschnittebenen der Schichten an verschiedenen Stellen unterschiedliche Abfolgen von Schichten entfernt sein.

Obwohl der Stapel von Materialschichten in vorangegangenen Ausführungsbeispielen stets die erste und die zweite Halbleiterschicht umfasst, ist es möglich, dass der Stapel aus mehreren Halbleiterschichten mit und/oder ohne dazwischen angeordneten Ätzstoppschichten gebildet wird.

Insbesondere erlaubt das Herstellungsverfahren der vorangegangenen Ausführungsbeispiele die Herstellung einer MEMS-Struktur, welche in den Bereichen der Torsionsfeder 58a und 58b und den Bereichen der Versteifungsfeder 54a und 54b eine von einander verschiedene Schichtdicke aufweist.

Durch eine individuelle Auslegung der Dicken von Aktuatoren, Versteifungsfedern, Torsionsfedern und Spiegelelementen lassen sich die dynamischen Eigenschaften des Gesamtsystems sehr gut justieren. Vorherig beschriebene Einschränkungen gegenwärtiger Verfahren lassen sich das oben beschriebene Verfahren umgehen.

Obwohl die vorangegangenen Ausführungsbeispiele stets die Herstellung einer MEMS-Struktur mit einem schwingfähig aufgehängten Mikrospiegel beschreiben, sind mit dem dargelegten Verfahren auch andere MEMS-Strukturen herstellbar, beispielsweise mechanische Mikroantriebe.

In anderen Worten ist die Geometrie von MEMS-Strukturen für deren gesamte Performance sehr wichtig. Dadurch ist es sinnvoll, verschiedene Teile einer Struktur je nach zugewiesener Funktion mit verschiedenen Schichtdicken zu konstruieren. Das durch die Ausführungsbeispiele beschriebene Prozessverfahren erlaubt eine genaue Definition und zugleich einen breiten realisierbaren Schichtdickenbereich der verschiedenen Schichtdicken in einer MEMS-Struktur.

Um bestimmte Schichtdicken an den gewünschten Stellen zu ermöglichen, reicht ein zeitlich gesteuerter Ätzprozess nicht aus. Für das in den Ausführungsbeispielen beschriebene Prozessverfahren werden an einem Substrat angeordnete doppelte Polysilizium-Schichten verwendet, statt normalen SOI-Wafer. Zwischen zwei Polysiliziumschichten und zwischen einer Polysiliziumschicht und einer Siliziumschicht des Substrates ist jeweils eine Oxid-Schicht angeordnet, welche als Ätzstopp für das rückseitige Ätzen fungiert. Durch Maskierung der Ätzstoppschichten wird der Wafer während des rückseitigen Ätzens lokal geätzt.

Dabei werden die Schichtdicken der MEMS-Struktur über die Dicken der Polysiliziumschichten und die Dicken der Ätzstoppschichten definiert, so dass sowohl Schichtdicken in verschiedenen lateralen Bereichen als auch die Kontur dieser Berieche genau einstellbar sind.

Die Möglichkeit, eine MEMS-Struktur mit mehreren, verschiedenen Schichtdicken herzustellen, erhöht die Freiheitsgrade beim Design der Strukturen erheblich. Dadurch, dass die Oxidschichten zwischen einzelnen Polysilizium- und/oder Siliziumschichten maskiert werden können und dadurch eine variable Schichtdicke aufweisen, die Oberfläche des Stapels aus Schichten dennoch eine ebene Oberfläche aufweist, können piezoelektrische Funktionsschichten auf die oberste Schicht des Stapels abgeschieden werden, was die Qualität der Herstellungsprozesse wesentlich erhöht.

## Patentansprüche

1. MEMS-Struktur mit
einem Stapel (12) mit einem Substrat (14), einer ersten Ätzstoppschicht (22), einer ersten Halbleiterschicht (24), einer zweiten Ätzstoppschicht (26), einer zweiten Halbleiterschicht (28), die in der genannten Reihenfolge auf einander angeordnet sind;
einem in dem Stapel (12) gebildeten Feder-Masse-System mit zumindest einer Feder (53a-d; 56a-d) und einem über die Feder (53a-d; 56a-d) aufgehängten Element (49);
und bei der das Feder-Masse-System in einer Dicke variiert, indem von einer der ersten Ätzstoppschicht (22) abgewandten Rückseite des Substrates (14) aus
an einer ersten Stelle das Substrat (14) unter Verbleib der ersten Halbleiterschicht (24); und
an einer zweiten, lateral von der ersten Stelle verschiedenen Stelle das Substrat (14), die erste Ätzstoppschicht (22) und die erste Halbleiterschicht (24);
entfernt sind; **dadurch gekennzeichnet, dass**
eine Aktuatorschicht (38a; 38b) so angeordnet ist, dass die zweite Halbleiterschicht (28) zwischen der zweiten Ätzstoppschicht (26) und der Aktuatorschicht (38a; 38b) angeordnet ist und so einen Aktuator (48a; 48b) für das Feder-Masse-System ausbildet.

2. Vorrichtung nach Anspruch 1, bei der die Aktuatorschicht (38a; 38b) piezoelektrische Materialien umfasst.

3. Vorrichtung nach einem der Ansprüche 1 oder 2 bei der die zumindest eine Feder (53a-d; 56a-d) in der Dicke variiert, um eine Versteifungsfeder (53a-d) in einem ersten Abschnitt der Feder (53a-d; 56a-d) und einen mechanisch aktiven Bereich (56a-d) der Feder (53a-d; 56a-d) in einem zweiten Abschnitt der Feder (53a-d; 56a-d) zu bilden, wobei der erste Abschnitt dicker als der zweite Abschnitt ist, so dass der mechanisch aktive Bereich (56a-d) eine gegenüber der Versteifungsfeder (53a-d) kleinere Steifigkeit aufweist.

4. Vorrichtung nach einem der Ansprüche 1-3, bei der Schichtdicke des aufgehängten Elementes (49) mehr als 1 % seiner längsten lateralen Ausdehnung beträgt.

5. Vorrichtung nach einem der Ansprüche 1-4, bei der in einem mechanisch aktiven Bereich (56a-d) der Feder (53a-d; 56a-d) oder in einem Aufhängebereich (46a; 46b), der über den mechanisch aktiven Bereich (56a-d) der Feder (53a-d; 56a-d) von dem aufgehängten Element (49) getrennt ist, eine Aktuatorschicht (38a; 38b) so angeordnet ist, dass die zweite Halbleiterschicht (28) zwischen der zweiten Ätzstoppschicht (26) und der Aktuatorschicht (38a; 38b) angeordnet ist und eine Dicke der Aktautorschicht (38a; 38b) zwischen 1 % und 1.000 % einer Dicke des aufgehängten Elementes (49) beträgt.

6. Vorrichtung nach einem der vorangegangenen Ansprüche, bei der die Dicke des Feder-Masse-Systems in Stufen variiert, die aus einem Entfernen einer unterschiedlichen Anzahl an Schichten des Stapels (12) von der ersten Ätzstoppschicht (22) abgewandten Rückseite des Substrates (14) aus resultieren.

7. Vorrichtung nach Anspruch 6, bei der der mechanisch aktive Bereich (56a-d) der zumindest einen Feder (53a-d; 56a-d) als Torsionsfeder ausgebildet ist.

8. Vorrichtung nach einem der Ansprüche 1-7, bei der die erste und die zweite Halbleiterschicht (24; 28) eine von einander verschiedene Schichtdicke umfassen.

9. Vorrichtung nach einem der Ansprüche 1-8, bei der die erste Ätzstoppschicht (22) an Stellen, an denen das Substrat (14) unter Verbleiben der ersten Halbleiterschicht (24) entfernt ist, als Rest einer Ätzmaske für die erste Halbleiterschicht (24) vorhanden ist.

10. Verfahren zum Herstellen einer MEMS-Struktur mit einem Stapel (12) von Materialdicken mit folgenden Schritten:
Bereitstellen eines Stapels (12) aus einem Substrat (14), einer ersten Ätzstoppschicht (22), einer ersten Halbleiterschicht (24), einer zweiten Ätzstoppschicht (26) und einer zweiten Halbleiterschicht (28), die in der genannten Reihenfolge auf einander angeordnet sind;
Ausbilden eines in dem Stapel (12) gebildeten und in seiner Dicke variierenden Feder-Masse-Systems mit zumindest einer Feder (53a-d; 56a-d) und einem über die Feder (53a-d; 56a-d) aufgehängten Element (49) durch
Entfernen, an einer ersten Stelle, des Substrates (14) unter Verbleib der ersten Halbleiterschicht (24); und
Entfernen, an einer zweiten, lateral von der ersten Stelle verschiedenen Stelle, des Substrates (14), der ersten Ätzstoppschicht (22) und der ersten Halbleiterschicht (24);
jeweils von einer der ersten Ätzstoppschicht (22) abgewandten Rückseite des Substrates (14) aus; **gekennzeichnet durch**
Anordnen piezoelektrischer Aktuatorschichten (36a-b; 38a-b; 42a-b) an einer ebenen und unstrukturierten Isolationsschicht (32), so dass die zweite Halbleiterschicht (28) zwischen der zweiten Ätzstoppschicht (26) und den piezoelektrischen Aktuatorschichten (36a-b; 38a-b; 42a-b) angeordnet ist, und so einen Aktuator (48a; 48b) für das Feder-Masse-System ausbildet;
wobei das Anordnen der piezoelektrischen Aktuatorschichten (36a-b; 38a-b; 42a-b) vor dem Ausbilden des in seiner Dicke variierenden Feder-Masse-Systems ausgeführt wird.

11. Verfahren gemäß Anspruch 10, ferner umfassend:
Anordnen einer Aktuatorschicht (38a; 38b) auf einer dem Substrat (14) abgewandten Hauptseite des Stapels (12);
Entfernen des Substrates (14) oder des Substrates (14) und der ersten Halbleiterschicht (24) unter Verwendung von selektivem Ätzen, um zumindest zwei Federelemente in einer Dicke der zweiten und der ersten Halbleiterschicht (24) oder der zweiten Halbleiterschicht (28) inklusive oder abzüglich der ersten oder zweiten Ätzstoppschicht (22; 26) auszuformen.

12. Verfahren gemäß Anspruch 11, bei dem das Anordnen der Aktuatorschicht (38a; 38b) unter Verwendung piezoelektrischer Materialien erfolgt.

13. Verfahren gemäß einem der Ansprüche 10-12, bei dem die Bereitstellung des Stapels (12) folgenden Schritt umfasst.
Anordnung der ersten oder der zweite Ätzstoppschicht (22; 26) derart, dass die erste oder zweite Ätzstoppschicht (22; 26) eine über eine laterale Ausdehnung des Stapels (12) variierende Schichtdicke aufweist und
Anordnung der ersten oder zweiten Halbleiterschicht (24; 28) derart, dass die dem Substrat (14) abgewandte Hauptseite der ersten oder zweiten Halbleiterschicht (24; 28) eine ebene Oberfläche bildet.

14. Verfahren gemäß einem der Ansprüche 10-13, das zwischen dem Bereitstellen des Stapels (12) und dem Ausbilden des Feder-Masse-Systems folgender Schritt umfasst:
Entfernen, an lateral unterschiedlichen Stellen,
der zweiten Halbleiterschicht (28) unter Verbleib der ersten Halbleiterschicht (24); oder
der zweiten Halbleiterschicht (28), der zweiten Ätzstoppschicht (26) und der ersten Halbleiterschicht (24);
von einer dem Substrat (14) abgewandten Hauptseite des Stapels (12) aus.

## Claims

1. An MEMS structure comprising:
a stack (12) comprising a substrate (14), a first etch-stop layer (22), a first semiconductor layer (24), a second etch-stop layer (26), a second semiconductor layer (28) which are arranged one above the other in the order mentioned;
a spring-and-mass system formed in the stack (12) comprising at least one spring (53a-d; 56a-d) and an element (49) suspended via the spring (53-d; 56a-d);
and wherein the spring-and-mass system varies in thickness by removing, starting from a back side of the substrate (14) facing away from the first etch-stop layer (22):
at a first position, the substrate (14) while leaving the first semiconductor layer (24); and
at a second position, laterally different from the first position, the substrate (14), the first etch-stop layer (22) and the first semiconductor layer (24);
**characterized in that**
an actuator layer (38a; 38b) is arranged such that the second semiconductor layer (28) is arranged between the second etch-stop layer (26) and the actuator layer (38a; 38b) and implements an actuator (48a; 48b) for the spring-and-mass system.

2. The device in accordance with claim 1, wherein the actuator layer (38a; 38b) includes piezoelectric materials.

3. The device in accordance with any of claims 1 or 2, wherein the at least one spring (53a-d; 56a-d) varies in its thickness so as to form a stiffening spring (53a-d) in a first portion of the spring (53a-d; 56a-d) and a mechanically active region (56a-d) of the spring (53a-d; 56a-d) in a second portion of the spring (53a-d; 56a-d), the first portion being thicker than the second portion such that the mechanically active region (56a-d) comprises a smaller stiffness compared to the stiffening spring (53a-d).

4. The device in accordance with any of claims 1 to 3, wherein the layer thickness of the suspended element (49) is more than 1 % of its longest lateral extension.

5. The device in accordance with any of claims 1 to 4, wherein an actuator layer (38a; 38b) is arranged in a mechanically active region (56a-d) of the spring (53a-d; 56a-d) or in a suspension region (46a; 46b) which is separated from the suspended element (49) via the mechanically active region (56a-d) of the spring (53a-d; 56a-d) such that the second semiconductor layer (28) is arranged between the second etch-stop layer (26) and the actuator layer (38a; 38b) and a thickness of the actuator layer (38a; 38b) is between 1% and 1,000% of a thickness of the suspended element (49).

6. The device in accordance with any of the preceding claims, wherein the thickness of the spring-and-mass system varies in steps which result from removing a different number of layers of the stack (12) starting from the back side of the substrate (14) facing away from the first etch-stop layer (22).

7. The device in accordance with claim 6, wherein the mechanically active region (56a-d) of the at least one spring (53a-d; 56a-d) is implemented to be a torsion spring.

8. The device in accordance with any of claims 1 to 7, wherein the first and second semiconductor layers (24; 28) have varying layer thicknesses.

9. The device in accordance with any of claims 1 to 8, wherein at positions where the substrate (14) has been removed while leaving the first semiconductor layer (24), the first etch-stop layer (22) is present as a remainder of an etch-mask for the first semiconductor layer (24).

10. A method for manufacturing an MEMS structure with a stack (12) of material thicknesses, comprising:
providing a stack (12) of a substrate (14), a first etch-stop layer (22), a first semiconductor layer (24), a second etch-stop layer (26) and a second semiconductor layer (28) which are arranged one above the other in the order mentioned;
implementing a spring-and-mass system formed in the stack (12) and varying in its thickness, comprising at least one spring (53a-d; 56a-d) and an element (49) suspended via the spring (53a-d; 56a-d) by:
removing, at a first position, the substrate (14) while leaving the first semiconductor layer (24); and
removing, at a second position laterally different form the first position, the substrate (14), the first etch-stop layer (22) and the first semiconductor layer (24),
each time starting from a back side of the substrate (14) facing away from a first etch-stop layer (22); **characterized by**
arranging piezoelectric actuator layers (36a-b; 38a-b; 42a-b) on a planar and unpatterned insulation layer (32) such that the second semiconductor layer (28) is arranged between the second etch-stop layer (26) and the piezoelectric actuator layers (36a-b; 38a-b; 42a-b) and thus implements an actuator (48a; 48b) for the spring-and-mass system;
wherein arranging the piezoelectric actuator layers (36a-b; 38a-b; 42a-b) is performed before implementing the spring-and-mass system varying in its thickness.

11. The method in accordance with claim 10, further comprising:
arranging an actuator layer (38a; 38b) on a main side of the stack (12) facing away from the substrate (14);
removing the substrate (14) or the substrate (14) and the first semiconductor layer (24) using selective etching so as to implement at least two spring elements in a thickness of the second and the first semiconductor layers (24) or the second semiconductor layer (28) including the first or second etch-stop layer (22; 26) or minus the latter.

12. The method in accordance with claim 11, wherein arranging the actuator layer (38a; 38b) is done using piezoelectric materials.

13. The method in accordance with any of claims 10 to 12, wherein providing the stack (12) comprises:
arranging the first or the second etch-stop layer (22; 26) such that the first or second etch-stop layer (22; 26) comprises a layer thickness varying over a lateral extension of the stack (12); and
arranging the first or second semiconductor layer (24; 28) such that the main side of the first or second semiconductor layer (24; 28) facing away from the substrate (14) forms a planar surface.

14. The method in accordance with any of claims 10 to 13, comprising between providing the stack (12) and implementing the spring-and-mass system:
removing, at laterally different positions,
the second semiconductor layer (28) while leaving the first semiconductor layer (24); or
the second semiconductor layer (28), the second etch-stop layer (26) and the first semiconductor layer (24);
starting from a main side of the stack (14) facing away from the substrate (14).

## Revendications

1. Structure MEMS avec
une pile (12) avec un substrat (14), une première couche d'arrêt de gravure (22), une première couche semi-conductrice (24), une deuxième couche d'arrêt de gravure (26), une deuxième couche semi-conductrice (28) qui sont disposés l'un sur l'autre dans l'ordre mentionné;
un système ressort-masse formé dans la pile (12) avec au moins un ressort (53a à d; 56a à d) et un élément (49) suspendu par l'intermédiaire du ressort (53a à d; 56a à d);
et dans laquelle le système ressort-masse varie en épaisseur en éliminant à partir d'un côté arrière du substrat (14) opposé à la première couche d'arrêt de gravure (22)
à un premier endroit, le substrat (14), tout en conservant la première couche semi-conductrice (24); et
à un deuxième endroit différent, latéralement par rapport au premier endroit, le substrat (14), la première couche d'arrêt de gravure (22) et la première couche semi-conductrice (24);
**caractérisée par le fait que**
une couche d'actionnement (38a; 38b) est disposée de sorte que la deuxième couche semi-conductrice (28) soit disposée entre la deuxième couche d'arrêt de gravure (26) et la couche d'actionnement (38a; 38b) et constitue ainsi un actionneur (48a; 48b) pour le système ressort-masse.

2. Dispositif selon la revendication 1, dans lequel la couche d'actionnement (38a; 38b) comporte des matériaux piézoélectriques.

3. Dispositif selon l'une des revendications 1 ou 2, dans lequel l'au moins un ressort (53a à d; 56a à d) varie en épaisseur pour constituer un ressort de raidissement (53a à d) dans un premier segment du ressort (53a à d; 56a à d) et une zone mécaniquement active (56a à d) du ressort (53a à d; 56a à d) dans un deuxième segment du ressort (53a à d; 56a à d), le premier segment étant plus épais que le deuxième segment, de sorte que la zone mécaniquement active (56a à d) présente une rigidité inférieure à celle du ressort de raidissement (53a à d).

4. Dispositif selon l'une des revendications 1 à 3, dans lequel l'épaisseur de couche de l'élément suspendu (49) est de plus de 1% de son étendue latérale la plus grande.

5. Dispositif selon l'une des revendications 1 à 4, dans lequel dans une zone mécaniquement active (56a à d) du ressort (53a à d; 56a à d) ou dans une zone de suspension (46a; 46b) qui est séparée par la zone mécaniquement active (56a à d) du ressort (53a à d; 56a à d) de l'élément suspendu (49) est disposée une couche d'actionnement (38a; 38b) de sorte que la deuxième couche semi-conductrice (28) soit disposée entre la deuxième couche d'arrêt de gravure (26) et la couche d'actionnement (38a; 38b) et qu'une épaisseur de la couche d'actionnement (38a; 38b) soit comprise entre 1% et 1 000% d'une épaisseur de l'élément suspendu (49).

6. Dispositif selon l'une des revendications précédentes, dans lequel l'épaisseur du système ressort-masse varie par paliers qui résultent de l'éloignement d'un nombre différent de couches de la pile (12) du côté arrière du substrat (14) opposé à la première couche d'arrêt de gravure (22).

7. Dispositif selon la revendication 6, dans lequel la zone mécaniquement active (56a à d) de l'au moins un ressort (53a à d; 56a à d) se présente sous forme de ressort de torsion.

8. Dispositif selon l'une des revendications 1 à 7, dans lequel la première et la deuxième couche semi-conductrice (24; 28) comportent une épaisseur de couche différente l'une de l'autre.

9. Dispositif selon l'une des revendications 1 à 8, dans lequel la première couche d'arrêt de gravure (22) est présente sous forme de reste d'un masque de gravure pour la première couche semi-conductrice (24) à des endroits où le substrat (14) est éliminé tout en conservant la première couche semi-conductrice (24).

10. Procédé de fabrication d'une structure MEMS avec une pile (12) d'épaisseurs de matériau, aux étapes suivantes consistant à:
mettre à disposition une pile (12) constituée d'un substrat (14), d'une première couche d'arrêt de gravure (22), d'une première couche semi-conductrice (24), d'une deuxième couche d'arrêt de gravure (26) et d'une deuxième couche semi-conductrice (28) qui sont disposés l'un sur l'autre dans l'ordre mentionné;
réaliser un système ressort-masse formé dans la pile (12) et variant en épaisseur avec au moins un ressort (53a à d; 56a à d) et un élément (49) suspendu par l'intermédiaire du ressort (53a à d; 56a à d)
en éliminant, à un premier endroit, le substrat (14), tout en conservant la première couche semi-conductrice (24); et
en éliminant, à un deuxième endroit différent, latéralement par rapport au premier endroit, le substrat(14), la première couche d'arrêt de gravure (22) et la première couche semi-conductrice (24);
chaque fois à partir d'un côté arrière du substrat (14) opposé à la première couche d'arrêt de gravure (22);
**caractérisé par** le fait de
disposer des couches d'actionnement piézoélectriques (36a à b; 38a à b; 42a à b) sur une couche isolante plane et non structurée (32) de sorte que la deuxième couche semi-conductrice (28) soit disposée entre la deuxième couche d'arrêt de gravure (26) et les couches d'actionnement piézoélectriques (36a à b; 38a à b; 42a à b), et constitue ainsi un actionneur (48a; 48b) pour le système ressort-masse;
dans lequel la disposition des couches d'actionnement piézoélectriques (36a à b; 38a à b; 42a à b) est réalisée avant de former le système ressort-masse variant en épaisseur.

11. Procédé selon la revendication 10, comportant par ailleurs le fait de:
disposer une couche d'actionnement (38a; 38b) sur un côté principal de la pile (12) opposé au substrat (14);
éliminer le substrat (14) ou le substrat (14) et la première couche semi-conductrice (24) à l'aide d'une gravure sélective, pour former au moins deux éléments de ressort dans une épaisseur de la deuxième et de la première couche semi-conductrice (24) ou de la deuxième couche semi-conductrice (28), y compris ou à l'exclusion de la première ou de la deuxième couche d'arrêt de gravure (22; 26).

12. Procédé selon la revendication 11, dans lequel la disposition de la couche d'actionnement (38a; 38b) a lieu à l'aide de matériaux piézoélectriques.

13. Procédé selon l'une des revendications 10 à 12, dans lequel la mise à disposition de la pile (12) comporte l'étape suivante consistant à
disposer la première ou la deuxième couche d'arrêt de gravure (22; 26) de sorte que la première ou la deuxième couche d'arrêt de gravure (22; 26) présente une épaisseur de couche qui varie sur une étendue latérale de la pile (12), et
disposer la première ou la deuxième couche semi-conductrice (24; 28) de sorte que le côté principal de la première ou de la deuxième couche semi-conductrice (24; 28) opposé au substrat (14) forme une surface plane.

14. Procédé selon l'une des revendications 10 à 13, comportant, entre la mise à disposition de la pile (12) et la réalisation du système ressort-masse, l'étape suivante consistant à:
éliminer, à des endroits latéralement différents,
la deuxième couche semi-conductrice (28), tout en conservant la première couche semi-conductrice (24); ou
la deuxième couche semi-conductrice (28), la deuxième couche d'arrêt de gravure (26) et la première couche semi-conductrice (24);
à partir d'un côté principal de la pile (12) opposé au substrat (14).
